# EUROPEAN PATENT APPLICATION

(11) **EP 4 541 932 A1**
(43) Date of publication of application: **23.04.2025**
(21) Application number: 24179022.9
(22) Date of filing: 30.05.2024
(51) Int. Cl.: C23C 16/44, B08B 9/08, H01J 37/32, H01L 21/02, H01L 21/311

(54) **METHOD OF CLEANING A PLASMA PROCESSING DEVICE**

(30) Priority: 16.10.2023 GB 202315825
(71) Applicant: SPTS Technologies Limited, Newport Gwent NP18 2TA (GB)
(72) Inventor: Crook, Kathrine, Newport (GB); Royle, William, Newport (GB); Lane Jones, Caitlin, Newport (GB); Edmonds, Matt, Newport (GB); Gomez-Sanchez, Daniel, Newport (GB); Fragos, Constantine, Newport (GB); McGrath, James, Newport (GB)
(74) Representative: Wynne-Jones IP Limited

(57) **Abstract**

A method of cleaning a chamber of a plasma processing device to remove depositions formed after the plasma processing device has been used to deposit a dielectric material comprising silicon and carbon is provided, the method comprising the steps of:
• introducing a first cleaning gas mixture into the chamber through a first gas inlet in a first introducing step, the first cleaning gas mixture comprising a first oxygen-containing component;
• generating a first plasma in the chamber from the first cleaning gas mixture in a first cleaning step;
• introducing a second cleaning gas mixture into a remote plasma source in a second introducing step, wherein the second cleaning gas mixture comprises a fluorine-containing component;
• generating a second plasma in the remote plasma source from a second cleaning gas mixture in a remote plasma generating step, wherein the second plasma comprises fluorine radicals; and
• performing a second cleaning step by allowing fluorine radicals from the second plasma to enter the chamber and introducing a third cleaning gas mixture into the chamber at the same time as the fluorine radicals from the second plasma, wherein the third cleaning gas mixture comprises a second oxygen-containing component.

A plasma processing device comprising:

• a chamber;
• a plasma generating means configured, in use, to generate a plasma within the chamber;
• at least one gas inlet;
• a remote plasma source configured, in use, to generate a plasma;
• a connector connecting the remote plasma source to the chamber, and
• a controller.

## Description

This invention relates to a method of cleaning a chamber of a plasma processing device. This invention also relates to a plasma processing device.

### Background

The fabrication of devices such as semiconductor devices frequently involves the deposition of films such as dielectric films including silicon oxides, SiN, SiC, SiOC and SiCN. In many Back End of the Line (BEOL) and packaging applications there is also a requirement that these films are deposited at relatively low temperatures of below 450 °C to prevent damage or distortion of components, which can influence the depositing techniques available to deposit these films in a cost-effective manner. The most widely used technique to deposit low temperature films is Plasma Enhanced Chemical Vapour Deposition (PECVD), which utilizes a plasma to break down precursors in a chamber containing a substrate for deposition. This technique can produce excellent low temperature film properties with relatively high deposition rates. However, the deposition is not limited to the substrate surface, as the plasma extends beyond the surface of the substrate. This results in a build-up of deposited matter in the chamber over time. This deposited matter can become a particulate source to contaminate future deposition processes and therefore requires removal and surface treatment of the interior of the chamber. Ideally, the internal surfaces of the PECVD process chambers are cleaned and potentially coated without breaking vacuum, in order to maintain productive operation of the system. The frequency of these clean cycles will depend on the thickness of the deposited matter and the process conditions, for example deposition temperature, plasma power and the precursors used to form the required film.

In capacitively coupled parallel plate PECVD systems, the deposition plasma is produced by flowing process gases at reduced pressure into the chamber and applying an RF potential between a "showerhead", or gas distribution plate, and a substrate support where the substrate is placed. Following a deposition cycle, when the substrate has been removed from the system, clean gases can be introduced into the chamber through the showerhead and the RF potential can then be applied to clean the internal surfaces of the chamber. This chamber cleaning step can occur after each substrate or series of substrates, where the frequency of the cleaning step is determined by the efficacy of the cleaning step to control particulate generation. Subsequently, if required, a "pasting" deposition step can be carried out to coat the surfaces of the chamber. This step helps to cover any residual compounds remaining in the chamber due to the cleaning step and to provide a consistent surface coating. While this process gas change sequence is straightforward to achieve in practice, the cleaning process has limitations, primarily due to the relatively high proportion of free ions to free radicals in the RF plasma. The ion component tends to roughen the chamber component over time and the ions density varies significantly across the chamber, leading to some regions of the chamber taking a long period of time to clear whilst other regions are overexposed. Remote plasma sources located outside of the chamber, which produce a high radical concentration with relatively low ion density, can be employed to address these concerns. However, these sources add to system complexity and cost and their performance is dependent on the composition of the built up deposited matter on the chamber components.

The productivity of a PECVD is determined by the number of substrates processed in a fixed period of time. When the system is not depositing a film on substrates, during a cleaning step or a pre-deposition step when no substrate is present in the chamber, productive time is being wasted. In production environments it is essential that the time spent depositing films on the substrates is maximized, while maintaining a stable process within acceptable defectivity limits.

PECVD deposited dielectrics such as silicon oxides, SiN and SiOC can be readily etched with fluorine radicals F* from disassociated NF3. The reaction mechanism for the etching of SiO2 using a NF3 remote plasma can be seen below in (1) & (2).
(1) 2NF₃(g)→ N₂ (g) + 6F*
(2) SiO₂(s) + 4 F* → SiF₄(g) + O₂(g)

SiCN and SiC films with a high C content, typically greater than 20 at% C, are not effectively removed by F* radicals alone, as silicon is preferentially removed, resulting in residual carbon-based by-products remaining in the chamber, even after a prolonged clean.

What is therefore required is a method of efficiently cleaning a PECVD chamber to maximize productive time whilst maintaining film quality, substrate to substrate and within substrate uniformity, rate and defectivity within acceptable limits. By keeping cleaning times to a minimum, the consumption of cleaning gases can also be reduced, which in turn has cost and environmental benefits.

### Statement of Invention

The present invention, in at least some of its embodiments, seeks to address the above-described problems, desires and needs.

According to a first aspect of the present invention, there is provided a method of cleaning a chamber of a plasma processing device to remove depositions formed after the plasma processing device has been used to deposit a dielectric material comprising silicon and carbon, the method comprising the steps of:
- introducing a first cleaning gas mixture into the chamber through a first gas inlet in a first introducing step, the first cleaning gas mixture comprising a first oxygen-containing component;
- generating a first plasma in the chamber from the first cleaning gas mixture in a first cleaning step;
- introducing a second cleaning gas mixture into a remote plasma source in a second introducing step, wherein the second cleaning gas mixture comprises a fluorine-containing component;
- generating a second plasma in the remote plasma source from a second cleaning gas mixture in a remote plasma generating step, wherein the second plasma comprises fluorine radicals; and
- performing a second cleaning step by allowing fluorine radicals from the second plasma to enter the chamber and introducing a third cleaning gas mixture into the chamber at the same time as the fluorine radicals from the second plasma, wherein the third cleaning gas mixture comprises a second oxygen-containing component.

Without wishing to be bound by theory or conjecture, it is believed that the first plasma, generated within the chamber, provides ion bombardment to rapidly oxidize the depositions and produce modified depositions. However, as this first plasma does not remove the depositions, ion damage to the chamber surfaces and internal components is minimised. Subsequent introduction of the fluorine radicals generated in the second plasma in the remote plasma source and the second oxygen-containing component into the chamber results in activation of the second oxygen-containing component to further oxidise the depositions whilst increasing the residence time of the fluorine radicals, allowing for more effective removal of the modified depositions.

For the avoidance of doubt the term 'radicals' is intended to refer to uncharged reactive species having one or more unpaired electrons. The radicals may be atomic or molecular. It is expected that substantially all (95% or more) of the electrons and ions created in the remote plasma source do not reach the chamber.

The third cleaning gas mixture can be introduced into the chamber separately to the fluorine radicals from the second plasma. The third cleaning gas mixture can be introduced into the chamber through the first gas inlet. The fluorine radicals can be introduced into the chamber through a connector connecting the chamber and the remote plasma source. The chamber can comprise a gas inlet system that acts as a conduit for radicals produced in the remote plasma source and the first and second cleaning gas mixtures. The gas inlet system can comprise a showerhead. As is well known to the skilled reader, a showerhead is a gas supply element having a plurality of perforations or other apertures. The perforations or other apertures allow gas to be introduced evenly into the chamber. Typically, the showerhead comprises a first plate having at least one gas inlet and a second plate which carries the perforations or other apertures. The first and second plates are spaced apart to define a cavity. The gas inlet system can comprise the first gas inlet. The gas inlet system can comprise the second gas inlet.

The dielectric material can comprise a silicon carbon-nitride or silicon carbide. The dielectric material can comprise a hydrogenated silicon Carbon-nitride (SiCN:H). The dielectric material can comprise amorphous carbon. The dielectric material can comprise at least 20 at.% carbon. The dielectric material can comprise at least 30 at.% carbon.

The plasma processing device can be a PECVD device. The remote plasma source can be an inductively coupled plasma (ICP) source or any other suitable plasma source. The plasma generating means can be a radio frequency (RF) driven capacitively coupled parallel plate system. The plasma processing device can comprise a substrate support located within the chamber. The method can be performed after plasma processing of one or more substrates. The one or more substrates can comprise one or more semiconductor substrates. The one or more semiconductor substrates can comprise one or more silicon substrates. The one or more semiconductor substrates can comprise one or more semiconductor wafers, such as one or more silicon wafers. The method can be performed after an isolation or passivation plasma processing step. The method can be performed after a TSV, via reveal or interposer manufacture plasma processing step.

The first oxygen-containing component can be selected from 02, N₂O and O₃. The first oxygen-containing component can be O₂. The second oxygen-containing component can be selected from 02, N₂O and O₃. The second oxygen-containing component can be O₂. The fluorine-containing component can be NF₃. The first cleaning gas mixture can comprise at least one inert gas component. The at least one inert gas component of the first cleaning gas mixture can comprise Ar and/or He. The second cleaning gas mixture can comprise at least one inert gas component. The inert gas component of the second cleaning gas mixture can comprise Ar and/or He. The addition of at least one inert gas component such as Ar or He to the cleaning gas mixtures used in the generation of the first plasma and/or the second plasma can aid in initiation of the plasma and stabilize the generated plasma.

The ratio of the flow rate of the fluorine-containing component in sccm to the flow rate of the second oxygen-containing component in sccm can be from about 4:1 to about 2:3. The ratio of the flow rate of the fluorine-containing component in sccm to the flow rate of the second oxygen-containing component in sccm can be about 3:2. The flow rate of the first oxygen-containing component can be from about 200 sccm to about 2000 sccm. The flow rate of the first oxygen-containing component can be about 1000 sccm. The flow rate of the fluorine-containing component can be from about 1000 sccm to about 5000 sccm. The flow rate of the fluorine-containing component can be about 3000 sccm. The flow rate of the second oxygen-containing component can be from about 1000 sccm to about 5000 sccm. The flow rate of the second oxygen-containing component can be about 2000 sccm.

The chamber can be maintained under vacuum by a vacuum means, such as a vacuum pump. During the first introducing step and/or the first cleaning step, the chamber can be maintained at a pressure from about 500 mTorr (66700 Pa) to about 5000 mTorr (667000 Pa). During the first introducing step and/or the first cleaning step, the chamber can be maintained at a pressure of about 1000 mTorr (133000 Pa). During the second cleaning step, the chamber can be maintained at a pressure from about 500 mTorr (66700 Pa) to about 5000 mTorr (667000 Pa). During the second cleaning step, the chamber can be maintained at a pressure of about 2500 mTorr (333000 Pa).

During the first cleaning step, the plasma can be sustained in the chamber using a high frequency RF power. During the first cleaning step, the plasma can be sustained in the chamber using a high frequency RF power and a low frequency RF power. The high frequency RF power can have a frequency from 10 MHz to 20 MHz. The low frequency RF power can have a frequency of from 375 kHz to 2 MHz. The high frequency RF power can supply a power from about 500 W to about 1500 W during the first cleaning step. The high frequency RF power can supply a power of about 1000 W during the first cleaning step.

The first cleaning step can have a duration of from about 20 seconds to about 60 seconds. The first cleaning step can have a duration of about 30 seconds.

The second cleaning step can comprise monitoring the composition of the environment within the chamber and determining an end point of the second cleaning step based upon the composition of the environment within the chamber. The monitoring of the composition of the environment within the chamber can be performed by an infra red gas analyser.

No plasma can be generated in the chamber during the second cleaning step.

The method can further comprise the step of performing a pre-deposition chamber treatment after the second cleaning step.

According to a second aspect of the present invention, there is provided a plasma processing device comprising:
- a chamber;
- a plasma generating means configured, in use, to generate a plasma within the chamber;
- at least one gas inlet;
- a remote plasma source configured, in use, to generate a plasma;
- a connector connecting the remote plasma source to the chamber, wherein the connector is configured, in use, to allow radicals from a plasma generated in the remote plasma source to enter the chamber whilst preventing the majority of the ions created in the remote plasma source from entering the chamber; and
- a controller,
wherein the controller is configured, in use, to:
- introduce a first cleaning gas mixture into the chamber through a first gas inlet of the at least one gas inlet, the first cleaning gas mixture comprising a first oxygen-containing component;
- generate a first plasma in the chamber from the first cleaning gas mixture using the plasma generating means;
- introduce a second cleaning gas mixture into the remote plasma source , wherein the second cleaning gas mixture comprises a fluorine-containing component;
- generate a second plasma in the remote plasma source from a second cleaning gas mixture, wherein the second plasma comprises fluorine radicals; and
- allow fluorine radicals from the second plasma to enter the chamber through the connector and introduce a third cleaning gas mixture into the chamber at the same time as the fluorine radicals from the second plasma, wherein the third cleaning gas mixture comprises a second oxygen-containing component.

The plasma processing device can be a PECVD device. The remote plasma source can be an inductively coupled plasma (ICP) source or any other suitable plasma source. The plasma generating means can be a radio frequency (RF) driven capacitively coupled parallel plate system.

The controller can be configured, in use, to introduce the third cleaning gas mixture into the chamber through at least one gas inlet. The plasma processing device can comprise a monitoring device configured, in use, to monitor the composition of the environment within the chamber, wherein the controller is configured, in use, to determine the end point of the second cleaning step based upon the composition of the environment within the chamber as monitored by the monitor device. The monitoring device can comprise an infra red gas analyser.

The connector can be electrically insulating. The connector can be formed from a dielectric material such as a ceramic. The connector can comprise a plurality of gas conducting bores. The gas conducting bores can each have a diameter of less than 10mm, preferably less than 5mm. In this way, plasma generated in the remote plasma source is substantially prevented from reaching the chamber. The connector can comprise a plug having the plurality of gas conducting bores formed therethrough.

The chamber can comprise a gas inlet system that acts as a conduit for radicals produced in the remote plasma source. The gas inlet system can comprise a showerhead. The gas inlet system can comprise the first gas inlet. The gas inlet system can comprise the second gas inlet. The gas inlet system cab comprise additional gas inlets, such as a third gas inlet. The plasma processing device can comprise a substrate support located within the chamber.

For the avoidance of doubt, whenever reference is made herein to 'comprising' or 'including' and like terms, the invention is also understood to include more limiting terms such as 'consisting of' and 'consisting essentially of'. Whilst the invention has been described above, it extends to any inventive combination of the features set out above, or in the following description, drawings or claims. For example, any features disclosed in relation to the first aspect of the invention may be combined with any features of the second aspect of the invention and vice versa.

### Description of Figures

Aspects of methods and apparatuses in accordance with the invention will now be described with reference to the accompanying drawings, in which:
Figure 1 is a schematic representation of a plasma processing device in accordance with an embodiment of the invention;
Figure 2 is a graph showing the relative intensity of volatile components in the chamber against the duration of a comparative cleaning step;
Figure 3 is a graph showing the relative intensity of volatile components in the chamber against the duration of a comparative cleaning step;
Figure 4 is a graph showing the relative intensity of volatile components in the chamber against the duration of a comparative cleaning step;
Figure 5 is a graph showing the relative intensity of volatile components in the chamber against the duration of a comparative cleaning step; and
Figure 6 is a flow chart illustrating a method in accordance with an embodiment of the invention.

### Detailed Description

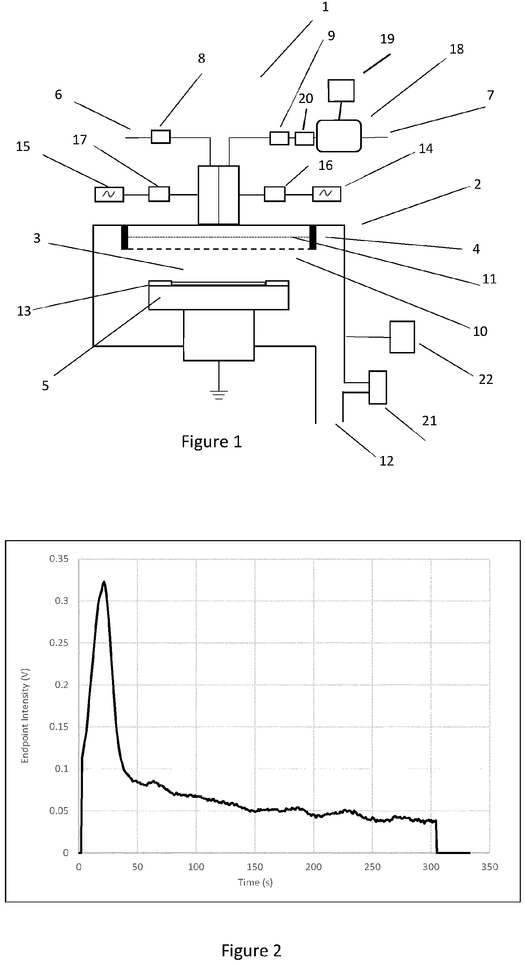

Figure 1 shows a schematic representation of a PECVD system 1 in accordance with an embodiment of the invention. Within a chamber 2, a process region 3, in which a plasma is created, is defined between a substrate support 5 and a gas inlet system comprising a showerhead 4. Gases pass into back of the showerhead 4 and are projected into the process region 3 through a series of small holes 10 which are isolated within the showerhead 4 by means of an internal gas distribution plate 11.The substrate support 5 is grounded and the showerhead 4 is powered by a plasma generating means comprising two different RF supplies 14, 15, each of which operate at different RF frequencies, and their associated matching units 16, 17. There is a dielectric break (not shown) between the aluminum showerhead 4 and the metallic chamber 2. Alternative plasma generating means, such as where the substrate support 5 is RF driven and the gas distribution plate 11 is grounded, could also be used. Process and cleaning gases enter the gas inlet system through pipes 6, 7 comprising isolation values 8, 9. Multiple gas sources are linked to pipes 6, 7 by means of a manifold (not shown) with isolation valves, mass flow controllers and related components. The chamber 2 is evacuated though line 12 by means of a pump (not shown).

A typical process cycle will commence by loading a substrate into the evacuated chamber 2 and placing the substrate onto substrate support 5. An annular uniformity ring 13 lies in close proximity to the edge of the substrate on the substrate support surface. A process gas or gas mixture enters the system through gas pipe 6 with valve 8 open and enters the chamber 2 through the showerhead 4. When the desired gas flow and pressure are achieved by the system controller, RF power is delivered by either or both of the RF supplies 14, 15 to the showerhead 4, initiating a plasma within the chamber 2 between the showerhead 4 and the substrate support 5. The high frequency RF supply 14 is typically operates at 10-20 MHz while the low frequency RF supply 15 typically operates at 375 kHz - 2 MHz. Matching units 16 and 17 enable efficient coupling of the RF into the showerhead 4. When the desired thickness of deposition has been achieved, the power is switched off and the process gas flow is stopped. The chamber 2 is evacuated and then the substrate is removed from the chamber.

In a typical remote chamber cleaning process, the reactive cleaning gases and any inert gases pass through gas pipe 7, connector 20, remote plasma source 18 and valve 9 through the showerhead 4 and into the chamber 2. Power is then delivered to the remote source 18 from power supply 19 to produce a high density plasma in the remote source 18, which in turn provides a source of radicals to clean the chamber 2 through the connector 20. The connector 20 can be provided at any location downstream of the remote source 18 before the showerhead 4. The connector 20 can be electrically insulating, such as a dielectric connector, and can be provided with a plurality of gas conducting bores having a diameter of less than 10 mm, to ensure that the energetic ions in the plasma generated in the remote plasma source 18 does not reach the chamber 2, but that radicals do reach the chamber 2.

To determine chamber clean end point, a monitoring device 21, in this case an infra red gas analyzer, is used in the exhaust line 12. By monitoring the characteristics, such as the IR signature, of the gases and volatile components leaving the chamber 2 by the exhaust line 12, it is possible to map the intensity of the emissions as a function of time and in turn determine when the chamber 2 has been fully cleaned. The system 1 further comprises a controller 22, configured to control each component of the system 1 in both normal modes of operation and cleaning modes.

Experimental work was carried out using a Delta^{™} fxP PECVD system manufactured by SPTS of Newport, UK. This is a capacitively coupled mixed frequency parallel plate single wafer PECVD system. Using 300 mm silicon wafers, with a standard thickness of approximately 775 µm, silicon carbon-nitride films, within the thickness range 150 nm to 500 nm, were deposited on bare silicon wafers and the clean parameters modified to determine the optimum clean process chemistry and physics. However, alternative plasma processing systems, substrate materials, substrate sizes and dielectric films comprising silicon and carbon could also be used. An MKS Astron ^{™} reactive gas generator was used as the remote source. Other forms of plasma generator might be contemplated instead. All clean cycles used the same deposition thickness and silicon carbon-nitride film. The end point time included a fixed over etch period to support long term chamber performance. The silicon carbon-nitride films deposited by PECVD under standard BEOL conditions at a temperature of less than 450 °C have a significant hydrogen content and are therefore more precisely defined as SiCN:H films. However, for brevity, such films and deposits are referred to as SiCN.

In a first comparative example, a remote plasma NF₃ clean was performed following SiCN deposition. The end point trace results of the monitoring of the gas compositions and volatile compounds are shown in Figure 2, where the X-axis indicates clean time while the Y-axis shows the relative intensity of the volatile compounds in the exhaust line. After about 25 seconds, the emissions peak, then rapidly drop by about 50 seconds and slowly falls until the remote plasma is extinguished. Even after about 300 seconds, there are still volatile products being detected in the exhaust line, which indicates the end point has not been reached and the chamber is not completely clean. It was determined that, to finish clean the chamber and reach the end point, a further 200 seconds of remote plasma generation was required. For comparison, a comparable thickness of SiO₂ deposition would require less than 80 seconds to reach the cleaning end point under similar process conditions.

In a second comparative example, the cleaning method was then modified to include a capacitive RF oxygen plasma within the PECVD chamber for a 60 second duration at a chamber pressure of 1000 mTorr prior to a remote plasma source clean. A 1000 sccm O₂ flow is introduced into the PECVD chamber through the showerhead in a first introducing step and 1000W of high frequency RF power is coupled into the PECVD chamber via the showerhead to ignite the O₂ to form a first, oxygen-containing plasma in a first cleaning step. During the first cleaning step, there is no significant CO or CO₂ IR absorption as monitored by the infra red gas analyzer. Without wishing to be bound by theory or conjecture, it is believed that, rather than removing the SiCN deposits, the carbon content within the SiCN deposits is being oxidized by the oxygen-containing plasma to form a SiCON modified deposit. These modified SiCON deposits can then be etched more effectively in the subsequent remote plasma clean.

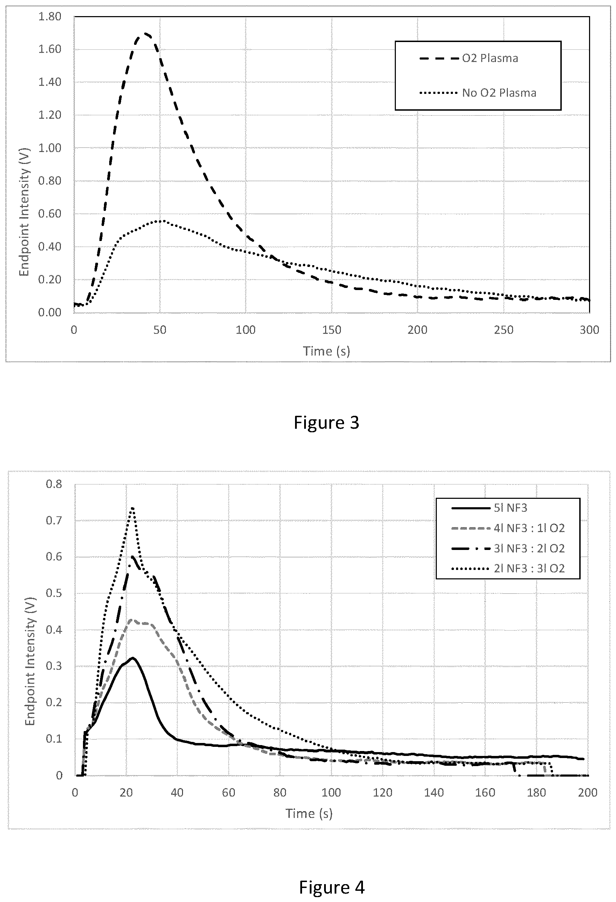

Figure 3 shows the effect of an initial RF oxygen plasma prior to a NF₃ remote plasma clean step compared to the comparative example illustrated in Figure 2. It can be seen that there is a significant increase in the integrated emission intensity when compared to an equivalent amount of deposition being cleaned with the NF₃ remote plasma alone. This suggests that, although both methods reach the cleaning end point at approximately the same time, as measured by the IR detector, it is likely that residual non-volatile materials are present in the chamber following the method comprising an initial oxygen-containing plasma clean.

It was found that stable RF oxygen plasma could be maintained in the chamber at pressures from 500 mTorr to 5000 mTorr, using gas flows from 200 sccm to 2000 sccm and RF powers of from 500 W to 1500 W, affording a wide process window for the first cleaning step.

Modification of the remote clean chemistry of the second cleaning step was then investigated in a third comparative example, by maintaining a pressure of 2500mT within the chamber with a total reactive gas flow of 5000 sccm and varying the NF₃ flow through the remote plasma source to establish optimized process conditions. Each test was performed without a first cleaning step using an oxygen-based plasma inside the chamber. In cleaning of SiCN deposits, the optimal ratio was determined to be a reduced NF₃ flow of 3000 sccm with 2000 sccm of an oxygen-containing component, in this case O₂ gas. However, it is expected that this particular optimal ratio would depend on the nature of the deposits to be removed. Without wishing to be bound by any theory or conjecture, it is believed that the addition of the oxygen-containing component to the remotely generated plasma results in activation of the oxygen-containing component, allowing for oxidation of the constituent carbon in the SiCN deposits. It was also determined that, by mixing the remotely ionized free fluorine radicals with the oxygen-containing component inside the PECVD showerhead and chamber, rather than in the remote source, increases the residence time of the fluorine radicals, allowing for more effective etching of the modified SiCON deposits. These effects combine to result in a shorter time to completely clean the chamber of deposits, as shown in Figure 4 and summarized in table 1:

**Table 1: SiCN clean times for NF₃:O₂ ratios of 5:0 to 2:3 at 2500mTorr**

| NF₃: O₂ Ratio | Clean Time (s) |
|---|---|
| 5:0 | >200 |
| 4:1 | 185 |
| 3:2 | 170 |
| 2:3 | 185 |

The first cleaning step, comprising the oxygen-containing plasma, was then combined with the subsequent modified remote plasma cleaning step to further reduce the time taken for the chamber to clean to completion. The combination of a first cleaning step, comprising the generation of a first plasma within the chamber comprising an oxygen-containing component, and a second cleaning step, comprising the generation of a plasma in a remote source from a fluorine-containing component and the subsequent cleaning of the chamber by fluorine radicals and an oxygen-containing component, was determined to reduce the chamber clean time, as well as preventing residue build up within the PECVD chamber that could hamper the long-term performance of the chamber through particle generation. This is evidenced by trace amounts of residue build up witnessed during a post deposition and clean chamber inspection. In the absence of the first plasma clean, a yellow/orange coating was observed to gradually develop on internal surfaces such as the lining of the chamber and the showerhead, over a large number of depositions. However, when cleaned with the combined first cleaning step and second cleaning step of the present invention, this coating was not observed.

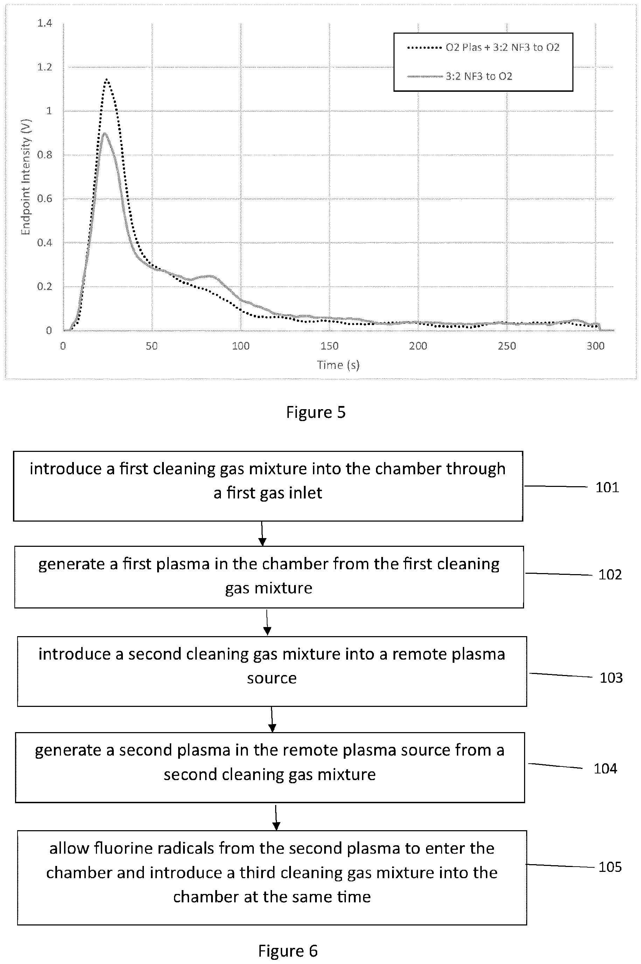

Figure 5 shows a comparison between a standard remote plasma clean, the modified remote plasma clean and the combined first cleaning step and second cleaning step in accordance with the present invention. In can be seen in Figure 5 that, when combining the first cleaning step and the subsequent second cleaning step, there is an increase in peak intensity of the IR Gas analyzer signal for Si-F and etch rate compared to the modified remote clean only. Table 2 shows the best achieved clean times for individual clean modifications and the combination of clean modifications.

**Table 2: SiCN PECVD deposition total clean time for different clean methods and chemistries. * based upon end point data.**

| Clean Modifications | Clean Time (s) |
|---|---|
| NF₃ remote plasma | >500 |
| 3:2 NF₃:O₂ Ratio remote plasma | 170 * |
| O₂ RF Plasma + 3:2 NF₂:O₂ Ratio Remote plasma | 230 |

A method of cleaning a chamber of a plasma processing device, in this case a PECVD device, to remove depositions formed after the plasma processing device has been used to deposit a dielectric material comprising silicon and carbon in accordance with an exemplary embodiment of the present invention is summarized in Figure 6. In a first introducing step 101, with any substrate removed from the PECVD chamber and previous gaseous or volatile components evacuated from the chamber, a first cleaning gas mixture comprising a first oxygen-containing component is introduced into the chamber. In one embodiment, the first cleaning gas mixture comprises or consists of O₂ gas, which is introduced into the chamber to achieve a partial pressure of approximately 1000mT. In a first cleaning step 102, a first plasma is generated in the chamber between the showerhead and the wafer support by application of RF power for approximately 30 seconds to oxidize the carbon content of the deposits. The exact duration of the first cleaning step is dependent on the thickness and the carbon content of the deposits. The RF plasma is then extinguished. In a second introducing step 103, a second cleaning gas mixture comprising a fluorine-containing component, in this case NF₃, is injected into the remote plasma source. In a remote plasma generating step 104, the fluorine-containing component is disassociated when power is applied to the remote plasma source to generate fluorine radicals. In a second cleaning step 105, the fluorine radicals and a third cleaning gas mixture comprising a second oxygen-containing component, in this case O₂ gas, are delivered to the showerhead and introduced into the chamber to clean the modified deposits. Preferably, no plasma is generated within the chamber during the second cleaning step, to prevent damage of the exposed surfaces of the chamber and internal components from ions as the deposits are removed. The duration of the second cleaning step will depend on the deposit composition and thickness and can be performed for a set period of time or, if monitoring to an end point, the second cleaning step would terminate on determination of the end point and the end of the cleaning process. At the end point, all gases are evacuated from the chamber and, if required, the chamber would be purged prior to any pre-deposition chamber treatment steps. At this point, the chamber is then ready for subsequent substrate processing.

Without being bound by any particular theory or conjecture, it is believed that the first plasma within the chamber oxidizes the carbon content of the deposits and produces a modified deposit, as indicated by the absence of CO and CO₂ IR absorption in the exhaust line. The first plasma provides ion bombardment to rapidly oxidize the deposits. However, as this energetic plasma does not remove the deposits themselves, ion damage to the chamber surfaces are avoided. In the second introducing step and second cleaning step, by not mixing the fluorine-containing component and oxygen-containing component in the remote source, fluorine radical density in the chamber, and in turn deposit etch rate, is increased due to reduced recombination, while the O₂ is dissociated as it reaches the showerhead to aid in further modification of the deposits.

## Claims

1. A method of cleaning a chamber of a plasma processing device to remove depositions formed after the plasma processing device has been used to deposit a dielectric material comprising silicon and carbon, the method comprising the steps of:
• introducing a first cleaning gas mixture into the chamber through a first gas inlet in a first introducing step, the first cleaning gas mixture comprising a first oxygen-containing component;
• generating a first plasma in the chamber from the first cleaning gas mixture in a first cleaning step;
• introducing a second cleaning gas mixture into a remote plasma source in a second introducing step, wherein the second cleaning gas mixture comprises a fluorine-containing component;
• generating a second plasma in the remote plasma source from a second cleaning gas mixture in a remote plasma generating step, wherein the second plasma comprises fluorine radicals; and
• performing a second cleaning step by allowing fluorine radicals from the second plasma to enter the chamber and introducing a third cleaning gas mixture into the chamber at the same time as the fluorine radicals from the second plasma, wherein the third cleaning gas mixture comprises a second oxygen-containing component.

2. The method according to claim 1, wherein the third cleaning gas mixture is introduced into the chamber separately to the fluorine radicals from the second plasma.

3. The method according to claim 1 or claim 2, wherein the dielectric material comprises a silicon carbon-nitride or silicon carbide.

4. The method according to any one of claims 1 to 3, wherein the dielectric material comprises at least 20 at.% carbon.

5. The method according to any one of claims 1 to 4, wherein the first oxygen-containing component and/or the second oxygen-containing component is O₂.

6. The method according to any one of claims 1 to 5, wherein the fluorine-containing component is NF₃.

7. The method according to any one of claims 1 to 6, wherein the ratio of the flow rate of the fluorine-containing component in sccm, to the flow rate of the second oxygen-containing component in sccm is from about 4:1 to about 2:3, and optionally said ratio is about 3:2.

8. The method according to any one of claims 1 to 7, wherein the flow rate of the fluorine-containing component is from about 1000 sccm to about 5000 sccm, and optionally said flow rate is about 3000 sccm.

9. The method according to any one of claims 1 to 8, wherein the flow rate of the second oxygen-containing component is from about 1000 sccm to about 5000 sccm, and optionally said flow rate is about 2000 sccm.

10. The method according to any one of claims 1 to 9, wherein, during the first introducing step, the chamber is maintained at a pressure from about 500 mTorr (66700 Pa) to about 5000 mTorr (667000 Pa) and/or, during the first cleaning step, the chamber is maintained at a pressure from about 500 mTorr (66700 Pa) to about 5000 mTorr (667000 Pa), and/or, during the second cleaning step, the chamber is maintained at a pressure from about 500 mTorr (66700 Pa) to about 5000 mTorr (667000 Pa).

11. The method according to any one of claims 1 to 10, wherein, during the first cleaning step, the plasma is sustained in the chamber using a high frequency RF power, and optionally the high frequency RF power supplies a power from about 500 W to about 1500 W during the first cleaning step.

12. The method according to any one of claims 1 to 11, wherein the first cleaning step has a duration of from about 20 seconds to about 60 seconds and/or the second cleaning step comprises monitoring the composition of the environment within the chamber and determining an end point of the second cleaning step based upon the composition of the environment within the chamber and/or the method further comprises the step of performing a pre-deposition chamber treatment after the second cleaning step.

13. The method according to any one of claims 1 to 12, wherein no plasma is generated in the chamber during the second cleaning step.

14. A plasma processing device comprising:
• a chamber;
• a plasma generating means configured, in use, to generate a plasma within the chamber;
• at least one gas inlet;
• a remote plasma source configured, in use, to generate a plasma;
• a connector connecting the remote plasma source to the chamber, wherein the connector is configured, in use, to allow radicals from a plasma generated in the remote plasma source to enter the chamber whilst preventing the majority of the ions created in the remote plasma source from entering the chamber; and
• a controller,
wherein the controller is configured, in use, to:
• introduce a first cleaning gas mixture into the chamber through a first gas inlet of the at least one gas inlet, the first cleaning gas mixture comprising a first oxygen-containing component;
• generate a first plasma in the chamber from the first cleaning gas mixture using the plasma generating means;
• introduce a second cleaning gas mixture into the remote plasma source , wherein the second cleaning gas mixture comprises a fluorine-containing component;
• generate a second plasma in the remote plasma source from a second cleaning gas mixture, wherein the second plasma comprises fluorine radicals; and
• allow fluorine radicals from the second plasma to enter the chamber through the connector and introduce a third cleaning gas mixture into the chamber at the same time as the fluorine radicals from the second plasma, wherein the third cleaning gas mixture comprises a second oxygen-containing component.

15. The plasma processing device according to claim 14, wherein the plasma processing device is a PECVD device and/or the controller is configured, in use, to introduce the third cleaning gas mixture into the chamber through at least one gas inlet.
